Europäisches Patentamt

European Patent Office

Office européen des brevets

(19)

(11) EP 0 840 363 A1

(12) EUROPEAN PATENT APPLICATION

(43) Date of publication:
06.05.1998 Bulletin 1998/19

(51) Int Cl.6: H01L 21/285, H01L 21/768,
C23C 16/34

(21) Application number: 97308740.6

(22) Date of filing: 31.10.1997

(84) Designated Contracting States:
AT BE CH DE DK ES FI FR GB GR IE IT LI LU MC
NL PT SE
Designated Extension States:
AL LT LV RO SI

(30) Priority: 31.10.1996 US 28793 P

(71) Applicant: TEXAS INSTRUMENTS
INCORPORATED
Dallas, Texas 75243 (US)

(72) Inventor: Lu, Jiong-Ping
Dallas, Texas 75243 (US)

(74) Representative: Williams, Janice et al
D. Young & Co.,
21 New Fetter Lane
London EC4A 1DA (GB)

(54) **Method for fabricating a conductive diffusion barrier layer by PECVD**

(57) An NH3-free process for preparing conformal, pure, and stable thin films of WNy, WSixNy and WBxNy, and WSiBxlNy at relatively low temperatures, by depositing the films in a plasma-enhanced chemical vapor deposition process, in which the nitrogen source is not an ammonium salt precursor.

```
101 ── HEAT THE WAFER TO
         DEPOSITION TEMPERATURE
                  │
102 ── N₂/H₂ PRE-DEPOSITION
         PLASMA TREATMENT (OPTIONAL)
                  │
103 ── WF₂/N₂/H₂ PLASMA-ENHANCED
         CHEMICAL VAPOR DEPOSITION
                  │
104 ── N₂/H₂ POST-DEPOSITION
         PLASMA TREATMENT (OPTIONAL)
                  │
         RAPID THERMAL
         ANNEALING (OPTIONAL)
```

FIG. 1

EP 0 840 363 A1

## Description

### BACKGROUND AND SUMMARY OF THE INVENTION

The present invention relates to integrated circuit structures and methods, and more particularly to barrier layers and their fabrication.

Tungsten based nitride films ($W_2N$ and related compounds, including $WN_y$, $WSi_xN_y$ and $WB_xN_y$) have been reported to have superior, diffusion barrier properties for advanced metallization applications, and particularly for use with copper metallization. For example, the use of tungsten nitride thin films as a barrier layer is disclosed in U.S. Patent No. 5,487,923 of Min et al. Typically, these barrier films are deposited using physical vapor deposition (PVD) through reactive sputtering of W, $WSi_x$ and $WB_x$ targets in nitrogen ambient. However, due to the directional nature of the sputtering method, the step coverage of deposited films is extremely poor for high aspect ratio contacts, vias, and trenches. Furthermore, this method has the disadvantage of making it difficult to change the stoichiometry of the films.

Another known method for preparing tungsten-based barrier films, which has an improved step coverage, is chemical vapor deposition (CVD). However, all known inorganic CVD processes use mixtures containing both $WF_6$ and $NH_3$. The present inventor has discovered that the reaction between $WF_6$ and $NH_3$ causes the severe problem of particulate formation (due to formation of the ammonium salt $NH_4F$).

### SUMMARY OF THE PRESENT INVENTION

Respective aspects of the present invention are set forth in claims 1, 11 and 18.

Embodiments of the invention present methods and processes for preparing conformal, pure, and stable thin films of $WN_y$, $WSi_xN_y$ and $WB_xN_y$, and $WSi_{x1}B_{x1}N_y$ at relatively low temperatures, by depositing the films in a plasma-enhanced CVD process, in which the nitrogen source (preferably $N_2$) is not an ammonium salt precursor. These films have the ability to act as diffusion barrier layers, which have many useful applications in the fabrication of integrated circuits, including metallization processes, DRAM word lines, and electrode-gate applications.

Advantages of embodiments of this process and of the resulting structure include:

better step coverage than sputtering processes;
flexibility in controlling chemical composition of the barrier films;
minimized formation of particles;
easy implementation (in fact the processes can be performed in commercial CVD reactors);
good diffusion barrier and stability properties under metalization which includes copper or other lifetime-killing elements;

good adhesion both to oxide layers and also to metal layers (such as copper); and
provides protection against etching of silicon or silicon oxide surfaces during deposition of metals from a perfluoro carrier species (such as $WF_6$).

### BRIEF DESCRIPTION OF THE DRAWINGS

The present invention will now be further described by way of example, with reference to selected illustrative embodiments shown in the accompanying drawings in which:

Figure 1 shows a process flow for preparing the $WN_x$ films;
Figure 2 shows characterization results of a thin film deposited by a process embodying the invention;
Figure 3 shows a via structure which includes a barrier metal film deposited by a process embodying the invention;
Figure 4 is a micrograph showing an actual example of copper metallization over a barrier metal film deposited by a process embodying the invention;
Figures 5A and 5B show two different metallization structures using the barrier/adhesion layer; and
Figure 6 shows the effect of thermal treatment on sheet resistance.

### DETAILED DESCRIPTION OF THE PREFERRED EMBODIMENTS

The teachings of the present invention will be described with particular reference to the presently preferred embodiment. However, it should be understood that this class of embodiments provides only a few examples of the many advantageous uses of the innovative teachings herein. In general, statements made in the specification of the present application do not necessarily delimit any of the various claimed inventions. Moreover, some statements may apply to some inventive features but not to others.

In general, particulate formation, during deposition of thin films which contain tungsten and nitrogen, can be reduced by use of a nitrogen source which is not an ammonium salt precursor.

In order to eliminate the particulate formation problem associated with the use of $NH_3$, $N_2$ gas is preferably used as a N-source for nitride barrier films and $H_2$ is used for capturing F, which is the by-product from the $WF_6$ precursor. However, because $N_2$ and $H_2$ are chemically inert, plasma enhancement is preferably used to reduce the process temperature in order to enable use of these processes in metallization applications, even at via level. The low deposition temperature allows these processes to be used in combination with low dielectric constant organic-based dielectric materials.

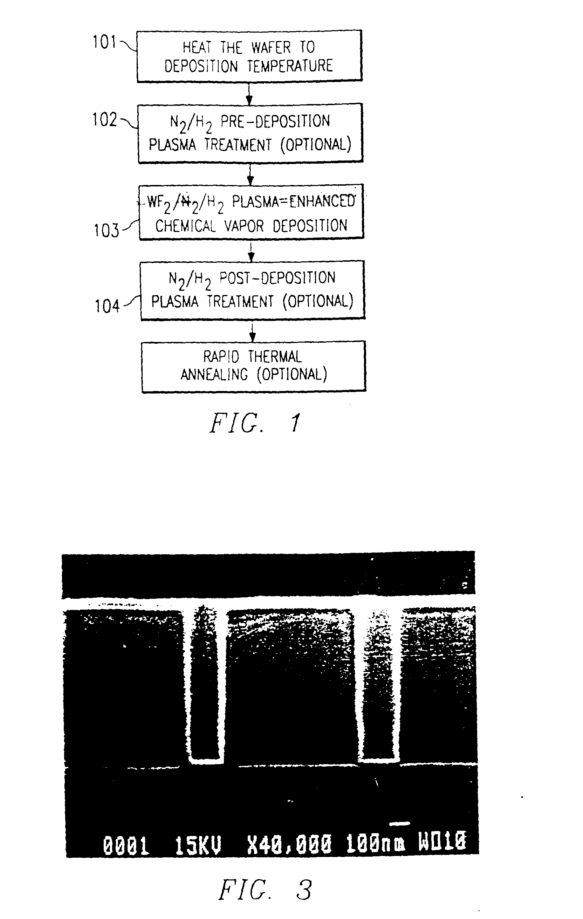

A sample process flow for fabricating $WN_x$ films is shown schematically in Figure 1. This process is preferably carried out in a plasma-enhanced chemical vapor deposition (PECVD) reactor with powered electrodes.

The wafer is first transferred to a pre-heated sample holder with typical temperatures in the range of 250-400°C. This heats the wafer to deposition temperatures (step 101). An optional plasma treatment step (step 102) can then be performed, to obtain additional control of film/substrate interface chemical composition. An $N_2/H_2$ mixture is used for this optional step (step 102), with typical plasma power between 200-500 W, typical reaction pressure in the range of 0.1-5 Torr, and typical flow rate of 100 - 500 sccm for both $N_2$ and $H_2$.

In the next step (step 103), the deposition of a $WN_x$ thin film is achieved by PECVD. The basic chemistry for the deposition step is based on the following reaction:

$$WF_6 + H_2 + N_2 \rightarrow WN_x + HF$$

Typical operating conditions for the deposition are:

| $WF_6$ flow | 2 - 5 sccm |
|---|---|
| $H_2$ flow | 50 - 500 sccm |
| $N_2$ flow | 50 - 500 sccm |
| Pressure | 0.1 - 5 torr |
| Power | 200 - 500 W |
| Temperature | 250 - 400°C |

After the deposition step (step 103) is carried out in the designated duration based on the thickness requirement, $WF_6$ flow is turned off. The plasma power can optionally be left on for an extra period of time (in the range of 0-120 seconds), while the $N_2$ and $H_2$ are still flowing (step 104), to offer additional control of surface nitrogen concentration. If the film is used where the thermal budget is not tight (such as at contact level or for gate application), an optional rapid thermal annealing (step 105) can be performed. This annealing step (step 105) further improves the properties of the films by reducing the resistivity and increasing the film density. The W/N atomic ratio is adjustable by changing the flow rates of the reactants.

In an alternative process, by adding either $SiH_4$ or $B_2H_6$ into the reaction mixture, $WSi_xN_y$ or $WB_xN_y$ can be prepared. These ternary compounds are amorphous and, therefore, provide improved diffusion barriers. Consequently, there is no risk of accelerated diffusion along grain boundaries. These processes can be summarized as follows:

$$WF_6 + H_2 + N_2 \rightarrow WN_y$$

$$WF_6 + H_2 + N_2 + SiH_4 \rightarrow WSi_xN_y$$

$$WF_6 + H_2 + N_2 + B_2H_6 \rightarrow WB_xN_y$$

$$WF_6 + H_2 + N_2 + SiH_4 + B_2H_6 \rightarrow WSi_{x1}B_{x2}N_y$$

The flow of $H_2$ serves to remove fluorine, which is present as a decomposition product of $WF_6$, from the reaction chamber.

The composition of the films does not have to be stoichiometric, but can be adjusted by changing the relative flow rate of the reactants. This provides another significant advantage of PECVD processes over PVD processes. Other Si and B source gases may also be used to replace $SiH_4$ and $B_2H_6$, respectively.

The present invention can also be used to produce quaternary films ($WSi_{x1}B_{x2}N_y$) if desired.

Sample Embodiments: $WN_y$ Deposition

The following tables give results from actual test runs using sample embodiments of the process described herein. In these tests a P-5000 reactor from Applied Materials was used to process six-inch (150cm) wafers.

| Starting Material: | PECVD-TEOS-derived $SiO_2$ |
|---|---|
| W Source Flow | 5 sccm of $WF_6$ |
| N Source Flow | 500 sccm of $N_2$ |
| Other Source | 500 sccm of $H_2$ |
| Susceptor Temp | 360°C |
| Total pressure | 4000 mTorr |
| RF power | 400 W |
| Time | 30 sec |
| Film Thickness | 50 nm |
| Composition | near $W_2N$ |
| Spacing | 350 mils |

The following table shows results at lower RF power and a significantly reduced pressure. Note that the electrode spacing is also larger than in the preceding experiment. This embodiment has an improved step coverage over the embodiment shown in the first table.

| Starting Material | PECVD-TEOS-derived $SiO_2$ |
|---|---|
| W Source Flow | 3 sccm of $WF_6$ |
| N Source Flow | 300 sccm of $N_2$ |
| Other Source | 450 sccm of $H_2$ |
| Susceptor Temp | 360°C |
| Total pressure | 500 mTorr |

(continued)

| Starting Material | PECVD-TEOS-derived SiO$_2$ |
|---|---|
| RF power | 250 W |
| Time | 90 sec |
| Film Thickness | 70 nm |
| Composition | usually W$_2$N |
| Spacing | 800 mils |

As will be apparent to those of ordinary skill in the art, the specific parameters can be varied. For example, decreasing the temperature improves the step coverage, but tends to leave an increased amount of residual fluorine. Therefore, in an alternative embodiment, a rapid thermal annealing step is used to strip the residual fluorine.

In addition, an increase in the pressure requires an increase in the power and a smaller electrode spacing. However, a higher pressure results in a higher rate and an inferior step coverage. The step coverage improves as the spacing increases.

Alternative Embodiment: Deposition Using NF$_3$

In a further class of embodiments, NF$_3$ can be used as the nitrogen source gas. In this case the reaction is

$$2NF_3 + 4WF_6 + 15H_2 \rightarrow 2W_2N + 30HF$$

NF$_3$ is a strong oxidizer, and the NF$_3$ and H$_2$ are preferably routed to the reaction chamber through separate manifolds, to prevent vapor-phase reaction. However, NF$_3$ is not an ammonium salt precursor, so it is predicted that low-particulate deposition will still be achieved.

Alternative Embodiment: Afterglow Sources

In another class of alternative embodiments, the wafer is not exposed to a plasma discharge. Instead a remote microwave discharge is used to provide a reactive nitrogen source which is not an ammonia precursor, and a fluorine scavenger. (Preferably these are atomic nitrogen and atomic hydrogen respectively.)

Sample Embodiments: WSi$_x$N$_y$ Deposition

The following table demonstrates a sample implementation of WSi$_x$N$_y$ deposition. Preferably silane is used as the silicon source, with a flow rate in the range of 2-10 sccm of SiH$_4$.

| Starting Material | PECVD-TEOS-derived SiO$_2$ |
|---|---|
| W Source Flow | 5 sccm of WF$_6$ |

(continued)

| Starting Material | PECVD-TEOS-derived SiO$_2$ |
|---|---|
| Si Source Flow | 2 sccm of SiH$_4$ |
| N Source Flow | 500 sccm of N$_2$ |
| Other Source | 500 sccm of H$_2$ |
| Susceptor Temp | 360°C |
| Total pressure | 4000 mTorr |
| RF power | 400 W |

The following table illustrates an actual test run using WSi$_x$N$_y$. This run produces a WSi$_x$N$_y$ with excessive resistivity, but this run did help to show the useful range of W/Si ratios. Specifically, this run demonstrates that the flow of the silicon source is preferably not more than twice that of the tungsten source.

| Starting Material | PECVD-TEOS-derived SiO$_2$ |
|---|---|
| W Source Flow | 5 sccm of WF$_6$ |
| Si Source Flow | 50 sccm of SiH$_4$ |
| N Source Flow | 500 sccm of N$_2$ |
| Other Source | 500 sccm of H$_2$ |
| Susceptor Temp | 360°C |
| Total pressure | 4000 mTorr |
| RF power | 400 W |

Sample Embodiments: WB$_{x1}$Si$_{x2}$N$_y$ Deposition

In another class of sample embodiments, both silicon and boron additives are used. The following table gives a sample predicted implementation using 2 sccm of SiH$_4$ and 2 sccm of B$_2$H$_6$ in the innovative process described herein. Preferably, both SiH$_4$ and B$_2$H$_6$ have a flow rate in the range of 1-3 sccm.

| Starting Material | PECVD-TEOS-derived SiO$_2$ |
|---|---|
| W Source Flow | 5 sccm of WF$_6$ |
| Si Source Flow | 1 sccm of SiH$_4$ |
| B Source Flow | 1 sccm of B$_2$H$_6$ |
| N Source Flow | 500 sccm of N$_2$ |
| Other Source | 500 sccm of H$_2$ |
| Temp | 360°C |
| Total pressure | 4000 mTorr |
| RF power | 400 W |

Sample Embodiments: WB$_x$N$_y$ Deposition

The following table shows a sample predicted implementation using 2 sccm of B$_2$H$_6$ in the process of the present embodiment. Preferably, B$_2$H$_6$ has a flow rate in the range of 1-5 sccm.

| Starting Material | PECVD-TEOS-derived SiO$_2$ |
|---|---|
| W Source Flow | 5 sccm of WF$_6$ |
| B Source Flow | 2 sccm of B$_2$H$_6$ |
| N Source Flow | 500 sccm of N$_2$ |
| Other Source | 500 sccm of H$_2$ |
| Temp | 360°C |
| Total pressure | 4000 mTorr |
| RF power | 400 W |

Sample Embodiments: Post-Deposition Thermal Treatment

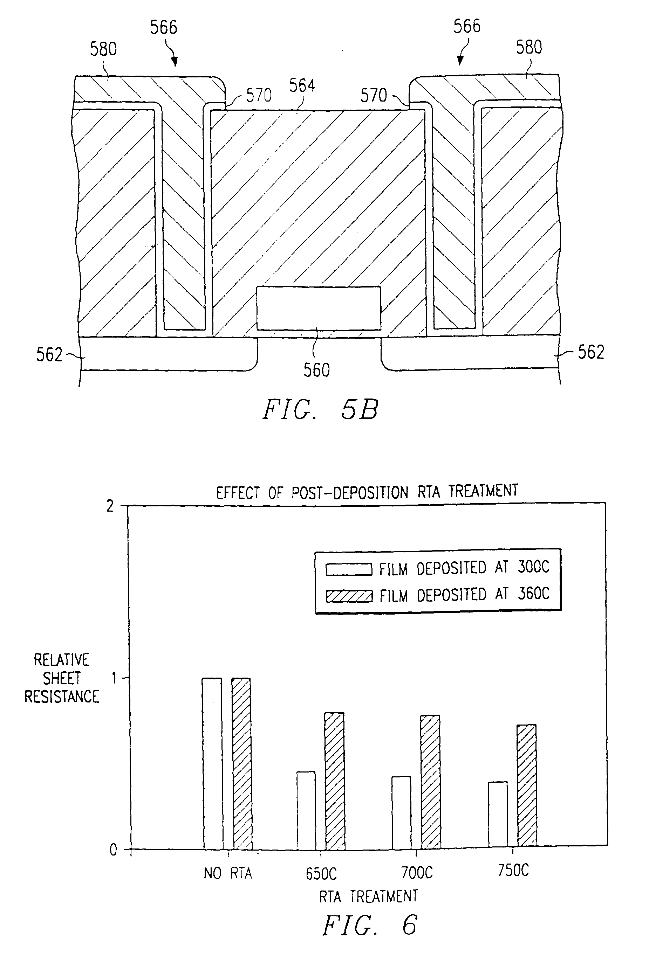

Figure 6 shows the effect of thermal treatment on sheet resistance. One set of bar graphs shows the effect of annealing after deposition at 300°C, and one shows the effect of annealing after deposition at 360°C. The two sets of bar graphs have been separately normalized, so that both show a starting sheet resistance of 1 (in arbitrary units). Actually the starting sheet resistance of the higher-deposition-temperature film is about 45 $\Omega$/cm, and the starting sheet resistance of the lower-deposition-temperature film is much higher. Annealing improves the sheet resistance of the lower-T deposited film dramatically, but improves the sheet resistance of the higher-temperature-deposited film by only about 20%. The film thickness of the higher-deposition-temperature film on which the sheet resistance was measured was estimated (from an SEM) as 400Å, so the bulk resistivity is estimated to be about 220m$\Omega$-$_\chi$. (This is only slightly worse than typical real-world values for production TiN processes.)

Characterization Results

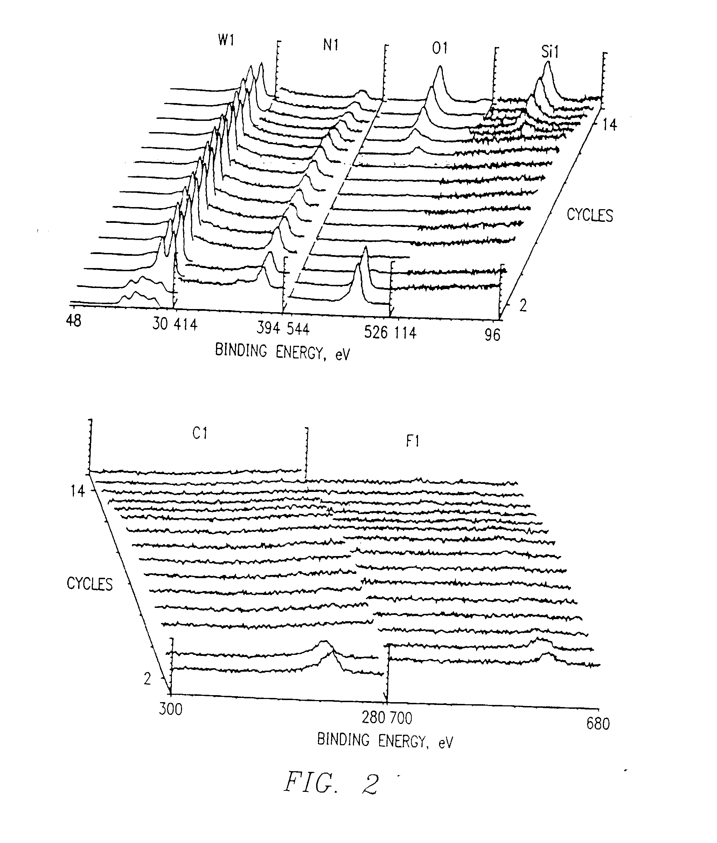

The resultant films obtained have a high purity level. Figure 2 summarizes x-ray photoelectron spectroscopy (XPS) depth profile data for a WN$_x$ film deposited by the above described innovative process. The data shows chemical compositions as a function of sputtering time (related to depth). No detectable O, C or F impurities can be observed in the bulk of the film. Rutherford back scattering spectrometric analysis indicated that the film has an atomic ratio of 2:1 for W/N. The W$_2$N film is highly stable, with no detectable change in film sheet resistance.

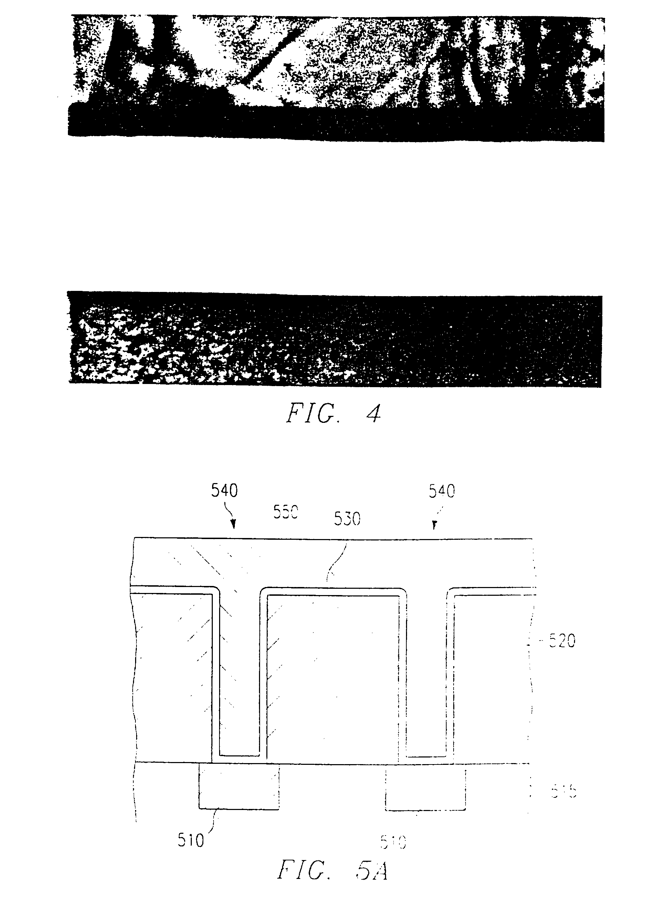

Films deposited using the process disclosed herein have excellent step coverage, as shown in the micrograph of Figure 3. This is a significant advantage over PVD processes.

The films prepared using the process disclosed herein have many applications in integrated circuit fabrication. As an example, Figure 4 shows a cross-sectional view (transmission micrograph, TEM) of a copper metallization structure using W$_2$N film as a barrier. The integrity of the multilayer structure remains after annealing at 550°C for 30 minutes. No detectable reaction at the Cu/W$_2$N interface is observed. These results indicate that the process works extremely well to provide a barrier layer in metallization procedures. Furthermore, W$_2$N films prepared using this process have excellent adhesion to SiO$_2$ and PVD cooper.

Sample Metallization Embodiment

The process disclosed herein can be utilized in metallization applications, particularly for copper (Cu) metallization. For example, in one application, as shown in Figure 5A, a partially fabricated structure is provided which includes transistors (not shown) beneath a conductor layer 510 (typically an aluminum alloy) which is surrounded by a lower interlevel dielectric 515. Thereafter, an upper interlevel dielectric 520 (eg. BPSG over TEOS-deposited SiO$_2$) is deposited and planarized by conventional methods (eg. chemical-mechanical polishing, or " CMP") . Thereafter (in a process of the type referred to as a "damascene") the interlevel dielectric 520 is patterned and etched to form slots 530 where lines of metallization are desired, and also to form deeper holes 540 where vias are desired (ie. where an electrical contact to the underlying conductor layer is desired) . Thereafter a diffusion barrier layer 530 is deposited, using one of the processes described above. A highly conductive metal 550 (eg. copper) is then deposited overall by conventional methods, and etched back overall (using eg. CMP) so that the flat surface of the interlevel dielectric 520 is exposed wherever the metal 550 is not present.

Note that, in this embodiment, the barrier layer runs over all exposed portions of the interlevel dielectric 520. That is, there are no locations where metal 550 comes directly in contact with the interlevel dielectric 520. This cuts down on the likelihood of copper atoms (or other lifetime killers such as gold) diffusing through an interlevel dielectric into the semiconductor substrate.

Second Sample Metallization Embodiment

Another metallization embodiment, as shown in Figure 5B, involves the formation of transistors with polycide gates 560 aligned to source/drain diffusions 562. A first interlevel dielectric layer 564 is subsequently formed. (Optionally, this is often followed by deposition and patterning of additional poly layers with corresponding additional interlevel dielectric layers, but these are not shown). Contact locations 566 are patterned and etched prior to the deposition of the barrier layer 570 using the processes disclosed herein. The metal layer 580 can then be deposited and patterned. In this sample embodiment, the metal layer 580 is an aluminum alloy, which is forced into the contact hole under superatmospheric pressure (using the "ForceFill™" process, in the presently preferred embodiment).

According to a disclosed class of embodiments, there is provided: A deposition process for fabricating a conductive diffusion barrier layer which includes tungsten and nitrogen, comprising the steps of: heating a wafer of semiconductor devices to a deposition temperature; and depositing a conductive diffusion barrier layer, which includes tungsten and nitrogen, onto said wafer from a source gas mixture which includes the combination of a tungsten source component and a nitrogen source component which is not an ammonium salt precursor; whereby said diffusion barrier layer provides protection for underlying structures, and facilitates adhesion of overlying metallization.

According to another disclosed class of embodiments, there is provided: A metallization process, comprising the steps of: providing a partially fabricated integrated circuit structure; depositing a diffusion barrier layer on said structure using plasma-enhanced chemical vapor deposition from a source gas mixture which includes the combination of a tungsten source component and a nitrogen source component which is not an ammonium salt precursor; and forming a metal layer on said diffusion layer; whereby said diffusion barrier layer provides protection for underlying structures, and facilitates adhesion of overlying metallization.

According to another disclosed class of embodiments, there is provided: A metallization process, comprising the steps of: providing a partially fabricated integrated circuit structure which includes transistors in a semiconductor material; depositing a diffusion barrier layer on said structure using chemical vapor deposition from a source gas mixture which includes $WF_6$, $N_2$, and a fluorine-scavenging component; and forming a metal layer on said diffusion layer; whereby said diffusion barrier layer provides protection for underlying structures, and facilitates adhesion of overlying metallization.

Modifications and Variations

As will be recognized by those skilled in the art, the concepts described in the present application can be modified and varied over a tremendous range of applications, and accordingly the scope of invention is not limited by any of the specific exemplary teachings given.

It is in principle possible to use another tungsten source gas, but there are not many suitable alternative candidates. The most attractive alternative candidate would appear to be $WCl_6$, which has the inconvenience of being a solid source.

In other metallization embodiments the overlying film may be gold or tungsten instead of aluminum or copper. (The disclosed barrier layer has been successfully tested under copper metallization, under gold metallization, under aluminum metallization, and under tungsten metallization. In each of these cases this barrier material was found to give good results.) Aluminum does not necessarily have to be deposited by the ForceFillÔ process, but can alternatively be deposited by CVD, or reflowed. Alternatively (and less preferably) a plug process can be used (although plug processes become less attractive at deep submicron dimensions). However, even with a plug process, the disclosed processes can provide improved adhesion and barrier properties for the plug as well as for the overlying metallization. In other metallization embodiments, the deposition of copper may be completed by electroplating after an initial layer has been deposited by the methods described above; in this class of embodiments, the diffusion barrier properties of the innovative films are particularly valuable.

The films produced by the processes described herein are advantageous in DRAM word line applications. For example, in such structures, a $WN_x$ thin film can be deposited according to the processes embodying the invention over a layer of polysilicon to provide a diffusion barrier layer prior to depositing the metal layer, typically tungsten. Thus this technology facilitates use of poly/metal layers (e.g. a polysilicon/$W_2N$/W stack) in contexts where polycide (polysilicon/silicide) layers might otherwise have been used. Such poly/metal layers advantageously provide lower sheet resistances than a comparably sized polycide layer.

Additionally, the diffusion barrier films produced by the processes embodying the invention can advantageously act as a contact barrier for aluminum to prevent junction spiking. Similarly, the barrier films can promote adhesion for metal layers such as copper and tungsten.

The high-quality diffusion barrier processes and structures provided by embodiments of the invention are particularly advantageous with copper metallization, since copper is a lifetime-killer in silicon. (That is, copper atoms in silicon form generation/recombination centers, which cause increased diode leakage and increased susceptibility to avalanching.) However, this problem is not unique to copper, and the present invention can also be advantageous with other metals (such as gold) which are lifetime-killers.

General background on plasma processing, CVD, and metallization is found in the following publications, which help to show the knowledge of those skilled in the art regarding variations and implementations: Coburn, PLASMA ETCHING AND REACTIVE ION etching (1982); Handbook of plasma processing technology (ed. Rossnagel); PLASMA ETCHING (ed. Manos and Flamm 1989); PLASMA PROCESSING (ed. Dieleman et al. 1982); Schmitz, CVD OF TUNGSTEN AND TUNGSTEN SILICIDES FOR VLSI/ULSI APPLICATIONS (1992); METALLIZATION AND METAL-SEMICONDUCTOR INTERFACES (ed. Batra 1989); VLSI METALLIZATION: PHYSICS AND TECHNOLOGIES (ed.

Shenai 1991); Murarka, METALLIZATION THEORY AND PRACTICE FOR VLSI AND ULSI (1993); HANDBOOK OF MULTILEVEL METALLIZATION FOR INTEGRATED CIRCUITS (ed. Wilson et al. 1993); Rao, MULTILEVEL INTERCONNECT TECHNOLOGY (1993); CHEMICAL VAPOR DEPOSITION (ed. M.L.Hitchman 1993); and the semiannual conference proceedings of the Electrochemical Society on plasma processing.

**Claims**

1. A method for fabricating a conductive diffusion barrier layer on a substrate comprising;

    heating the substrate to a deposition temperature; and
    depositing a conductive diffusion barrier layer over said substrate from a source gas mixture comprising a tungsten source component and a nitrogen source component, said diffusion barrier layer being arranged for providing protection of an underlying structure and for facilitating adhesion of an overlying metallization.

2. The method as claimed in Claim 1, wherein said step of depositing said conductive diffusion barrier layer comprises depositing a conductive diffusion barrier layer over said substrate from a source gas mixture comprising a nitrogen source component that is not an ammonium salt precursor.

3. The method as claimed in Claim 1 or Claim 2, wherein said step of depositing said conductive diffusion barrier layer comprises depositing a conductive diffusion barrier layer over said substrate from a source gas mixture including a nitrogen source component comprising $N_2$.

4. The method as claimed in any of Claims 1 to 3 further comprising;

    performing said step of depositing said conductive diffusion barrier layer at a temperature substantially between 250°C and 400°C.

5. The method as claimed in any of Claims 1 to 4 further comprising;

    performing a plasma pre-treatment prior to the step of depositing said conductive diffusion barrier layer; and
    performing a plasma post-treatment following the step of depositing said conductive diffusion barrier layer.

6. The method as claimed in any of Claims 1 to 5 further comprising;

    performing a rapid annealing process following the step of depositing said conductive diffusion barrier layer.

7. The method as claimed in any of Claims 1 to 6, wherein said step of depositing said conductive diffusion barrier layer comprises depositing a conductive diffusion barrier layer over said substrate from a source gas mixture including a tungsten source component comprising $WF_6$.

8. The method as claimed in Claim 7, wherein said step of depositing said conductive diffusion barrier layer comprises depositing a conductive diffusion barrier layer over said substrate from a source gas mixture comprising a flourine scavenging component.

9. The method as claimed in any of Claims 1 to 8, wherein said step of depositing said conductive diffusion barrier layer comprises depositing a conductive diffusion barrier layer over said substrate from a source gas mixture comprising a silicon source component.

10. The method as claimed in any of Claims 1 to 9, wherein said step of depositing said conductive diffusion barrier layer comprises depositing a conductive diffusion barrier layer over said substrate from a source gas mixture comprising a boron source component.

11. A metallization process comprising;

    depositing a diffusion barrier layer substantially over a partially fabricated integrated circuit structure using plasma-enhanced chemical vapour deposition from a source mixture comprising a tungsten source component and nitrogen source component; and
    forming a metal layer on said diffusion barrier layer, said diffusion barrier layer being arranged for providing protection of an underlying structure and for facilitating adhesion of an overlying metallization.

12. The process as claimed in Claim 11, wherein said step of depositing said conductive diffusion barrier layer comprises depositing a conductive diffusion barrier layer over said substrate from a source gas mixture comprising a nitrogen source component that is not an ammonium salt precursor.

13. The process as claimed in Claim 11 or Claim 12, wherein said step of forming said metal layer comprises forming a metal layer comprising copper.

14. The process as claimed in any of Claims 11 to 13, wherein said step of depositing said conductive diffusion barrier layer comprises depositing a conductive diffusion barrier layer over said substrate from a source gas mixture including a nitrogen source component comprising $N_2$.

15. The process as claimed in any of Claims 11 to 14 further comprising;

    performing said step of depositing said conductive diffusion barrier layer at a temperature substantially between 250°C and 400°C.

16. The process as claimed in any of Claims 11 to 15, wherein said step of depositing said conductive diffusion barrier layer comprises depositing a conductive diffusion barrier layer over said substrate from a source gas mixture comprising a silicon source component.

17. The process as claimed in any of Claims 11 to 16, wherein said step of depositing said conductive diffusion barrier layer comprises depositing a conductive diffusion barrier layer over said substrate from a source gas mixture comprising a boron source component.

18. A metallization process comprising;

    depositing a diffusion barrier layer substantially over a partially fabricated integrated circuit structure which includes at least one transistor using chemical vapour deposition from a source gas mixture comprising $WF_6$, $N_2$, and a flourine-scavenging component; and forming a metal layer on said diffusion barrier layer, said diffusion barrier layer being arranged for providing protection of an underlying structure and for facilitating adhesion of an overlying metallization.

19. The process as claimed in Claim 18, wherein said step of depositing said conductive diffusion barrier layer comprises depositing a conductive diffusion barrier layer over said substrate from a source gas mixture including a flourine-scavenging component comprising $H_2$.

20. The process as claimed in Claim 18 or Claim 19 further comprising;

    performing said step of depositing said conductive diffusion barrier layer at a temperature substantially between 250°C and 400°C.

21. The process as claimed in any of Claims 18 to 20, wherein said step of depositing said conductive diffusion barrier layer comprises depositing a conductive diffusion barrier layer over said substrate from a source gas mixture comprising a silicon source component.

22. The process as claimed in any of Claims 18 to 21, wherein said step of depositing said conductive diffusion barrier layer comprises depositing a conductive diffusion barrier layer over said substrate from a source gas mixture comprising a boron source component.

| | |
|---|---|
| 101 | HEAT THE WAFER TO DEPOSITION TEMPERATURE |
| 102 | $N_2/H_2$ PRE-DEPOSITION PLASMA TREATMENT (OPTIONAL) |
| 103 | $WF_2/N_2/H_2$ PLASMA-ENHANCED CHEMICAL VAPOR DEPOSITION |
| 104 | $N_2/H_2$ POST-DEPOSITION PLASMA TREATMENT (OPTIONAL) |
| | RAPID THERMAL ANNEALING (OPTIONAL) |

*FIG. 1*

0001  15KV  X40,000  100nm  WD10

*FIG. 3*

FIG. 2

FIG. 4

FIG. 5A

*FIG. 5B*

EFFECT OF POST-DEPOSITION RTA TREATMENT

*FIG. 6*

**European Patent Office**

**EUROPEAN SEARCH REPORT**

Application Number

EP 97 30 8740

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PATENT ABSTRACTS OF JAPAN<br>vol. 013, no. 173 (E-748), 24 April 1989<br>-& JP 01 005015 A (SHARP CORP), 10 January 1989,<br>* abstract * | 1-4,7,8, 11,12, 14,15, 18-20 | H01L21/285<br>H01L21/768<br>C23C16/34 |
| Y | | 10,13, 17,22 | |
| X | PATENT ABSTRACTS OF JAPAN<br>vol. 012, no. 030 (E-578), 28 January 1988<br>-& JP 62 188268 A (SONY CORP), 17 August 1987,<br>* abstract * | 1-3,7-9 | |
| A | | 4,11,12, 14-16, 18-21 | |
| X | WO 96 17104 A (MICRON TECHNOLOGY INC) 6 June 1996<br><br>* page 2, line 8 - line 22 *<br>* column 4, line 13 - column 5, line 13 *<br>* column 5, line 27 - line 30; claims 1,5,9,12 * | 1,4,7-9, 11,15, 16,18-21 | TECHNICAL FIELDS SEARCHED (Int.Cl.6)<br><br>H01L<br>C23C |
| Y | REID J S ET AL: "W-B-N DIFFUSION BARRIERS FOR SI/CU METALLIZATIONS"<br>THIN SOLID FILMS,<br>vol. 262, no. 1/02, 15 June 1995,<br>pages 218-223, XP000517382<br>* page 218, paragraph 1 * | 10,13, 17,22 | |

-/--

The present search report has been drawn up for all claims

| Place of search | Date of completion of the search | Examiner |
|---|---|---|
| BERLIN | 22 January 1998 | Klopfenstein, P |

**European Patent Office**

## EUROPEAN SEARCH REPORT

Application Number

EP 97 30 8740

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | LEE C W ET AL: "HIGH TEMPERATURE THERMAL STABILITY OF PLASMA-DEPOSITED TUNGSTEN NITRIDE SCHOTTKY CONTACTS TO GAAS" SOLID STATE ELECTRONICS, vol. 38, no. 3, 1 March 1995, pages 679-682, XP000492780 * page 679 * * page 681, right-hand column; figure 5 * * page 682, left-hand column * | 1,4,7,8 | |
| A | | 5,6,11, 15,18-20 | |
| | --- | | |
| X | PATENT ABSTRACTS OF JAPAN vol. 012, no. 306 (C-522), 19 August 1988 -& JP 63 076875 A (FUJITSU LTD), 7 April 1988, * abstract * | 1-4,7, 11,12, 14,15, 18,20 | |
| A | | | |
| | --- | | |
| D,X | US 5 487 923 A (MIN SUK-KI ET AL) 30 January 1996 * column 1, line 10 - line 22 * * column 1, line 62 - column 2, line 7 * * column 2, line 28 - line 58 * * column 2, line 66 - column 3, line 11 * * column 3, line 43 - line 64 * * column 4, line 18 - line 36; figures 2A,2B * | 1,4,7,8, 11,15 | TECHNICAL FIELDS SEARCHED (Int.Cl.6) |
| A | | 18-20 | |
| | --- | | |
| | -/-- | | |

The present search report has been drawn up for all claims

| Place of search | Date of completion of the search | Examiner |
|---|---|---|
| BERLIN | 22 January 1998 | Klopfenstein, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

**EUROPEAN SEARCH REPORT**

Application Number

EP 97 30 8740

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 414 267 A (APPLIED MATERIALS INC) 27 February 1991<br>* column 1, line 5 - line 21 *<br>* column 1, line 48 - column 2, line 4 *<br>* column 2, line 27 - line 35 *<br>* column 3, line 46 - column 4, line 2 *<br>* column 4, line 37 - line 52 *<br>* column 6, line 27 - line 39 *<br>* column 6, line 49 - column 7, line 3 *<br>* column 7, line 20 - line 45; example 1 * | 1-4,7,9 | |
| A | | 11,12,<br>14-16,<br>18,20,21 | |
| | ----- | | |

TECHNICAL FIELDS
SEARCHED (Int.Cl.6)

The present search report has been drawn up for all claims

| Place of search | Date of completion of the search | Examiner |
|---|---|---|
| BERLIN | 22 January 1998 | Klopfenstein, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)